# EUROPÄISCHE PATENTANMELDUNG

(11) **EP 1 187 515 A2**
(43) Veröffentlichungstag der Anmeldung: **13.03.2002**
(21) Anmeldenummer: 01121427.7
(22) Anmeldetag: 07.09.2001
(51) Int. Cl.: H05K 3/00, C25D 5/08

(54) **Verfahren und Vorrichtung zur Behandlung von Gegenständen, besonders Leiterplatten**

(30) Priorität: 07.09.2000 DE 10044209
(71) Anmelder: Gebr. Schmid GmbH & Co., D-72250 Freudenstadt (DE)
(72) Erfinder: Schmid, Dieter C., 72250 Freudenstadt-Dietersweiler (DE)
(74) Vertreter: Patentanwälte Ruff, Wilhelm, Beier, Dauster & Partner

(57) **Zusammenfassung**

Es wird ein Verfahren zur Behandlung von plattenförmigen Gegenständen, insbesondere zum galvanischen Auftrag von Metall, vorzugsweise Kupfer, auf ggf. aus mehreren Schichten aufgebaute Leiterplatten (mit Löchern), insbesondere Sacklöchern 16 beschrieben. Die Leiterplatten werden in einem Behandlungsbad 24 an Düsen 34 vorbeibewegt werden, aus denen Strahlen 35 von Behandlungsflüssigkeit 24 auf die Leiterplattenoberfläche und die Löcher 16 gerichtet werden. Während des Vorbeilaufes der Gegenstände 11 wird die Strahlenrichtung periodisch geändert.

Die Vorrichtung hat einen periodischen Schwenk- und/oder Oszillationsantrieb für die Düsen 34, und zwar schwenkt der Schwenkantrieb 41 die Düsen 34 um eine Achse im wesentlichen quer zur Transportrichtung 40. Der Oszillationsantrieb bewegt die Düsen 34 im wesentlichen quer zur Transportrichtung 40.

## Beschreibung

Die Erfindung betrifft ein Verfahren und eine Vorrichtung zur Behandlung von Gegenständen, besonders zum galvanischen Auftrag von Metall, insbesondere von Kupfer, auf insbesondere aus mehreren Schichten aufgebaute Leiterplatten mit Löchern, insbesondere Sacklöchern.

Bei der Leiterplattenherstellung werden die aus elektrisch isolierenden Werkstoffen bestehenden Leiterplatten galvanisch mit Metallen, insbesondere Kupfer, beschichtet. Die Leiterplatten haben zur Durchkontaktierung zu anderen Leiterplatten oder -leiterebenen Löcher, deren Innenwandungen ebenfalls metallisiert werden. Für einen mehrschichtigen Leiterplattenaufbau sind teilweise Sacklöcher vorgesehen, die zu einer unteren Leiterebene führen. Um einen schnellen und gleichmäßigen elektrogalvanischen Auftrag sicherzustellen, muss die Galvanoflüssigkeit an den zu galvanisierenden Oberflächen möglichst stark bewegt, d.h. ständig ausgetauscht werden. Dazu sind im Galvanobad eine große Anzahl von Düsen, meist in Düsenrohren zusammengefaßt, vorgesehen, aus denen Galvanoflüssigkeit auf die Leiterplattenoberfläche gestrahlt wird. Es wurde festgestellt, dass bei dieser Einrichtung die durch die Galvanisierung aufgebrachte Metallschicht, insbesondere im Bereich von Sacklöchern, die nicht von der Flüssigkeit durchströmt werden, nicht sehr gleichmäßig ausfiel.

### AUFGABE UND LÖSUNG

Aufgabe der Erfindung ist es, die Behandlung in einem Bad zu vergleichmäßigen und möglichst zu beschleunigen.

Diese Aufgabe wird durch die Ansprüche 1 und 4 gelöst.

Es hat sich gezeigt, dass durch die periodische Änderung der Strahlenrichtung während des Vorbeilaufs der Leiterplatten galvanischer Metallauftrag in seiner Schichtdicke und Qualität verbessert werden konnte. Dies gilt allgemein, jedoch insbesondere im Bereich von Sacklöchern, wo bisher aufgetretene Schichtverdickungen am äußeren Bohrungsrand, verbunden mit zu geringen Schichtdicken an der Bohrungsinnenwand, nicht mehr zu beobachten sind. Vielmehr ist die Schichtdicke über das gesamte Sackloch einschließlich des Sachlochbodens gleichmäßig und von guter, kompakter Qualität. Die Erfindung kann auch bei anderen Behandlunsverfahen angewandt werden, insbesondere, wenn es um einen möglichst schnellen und wirksamen Flüssigkeitsaustausch an den Oberflächen geht, z.B. bei Reinigungsverfahren oder das Aufbringen einer Kupferschicht durch chemische Reaktionen sowie elektrogalvanischem Abtragen.

Es ist bevorzugt, die Periodizität der Strahlenrichtungsänderung mit einer Frequenz vorzunehmen, die in Abhängigkeit von der Vorbeilaufgeschwindigkeit der Leiterplatte gewählt wird und vorzugsweise bei einem Hin- und Herschwenken je Millimeter des Leiterplattenvorschubs liegen kann.

Zu einer besonders guten Wirkung trägt es bei, wenn die Behandlungsflüssigkeit mit einer Austrittsgeschwindigkeit von 0,5 bis 10 m/s aus den Düsen austritt.

Es ist festgestellt worden, dass auch ein seitliches Oszillieren der Düsen zur Verbesserung des Ergebnisses, ggf. auch statt einer Strahlschwenkung, beiträgt. Zu erklären ist es dadurch, dass durch die Bewegung der aus den Düsen austretenden Strahlen in dem Galvanobad Strömungsverhältnisse, beispielsweise Turbulenzen, erzeugt werden, die eine Grenzschichtbildung verhindert und so durch den Galvanisierfortgang verbrauchte Galvanoflüssigkeit von den Oberflächen weg und frische Flüssigkeit an diese heran befördert.

Es hat sich gezeigt, dass schon relativ geringe Schwenkwinkel zu einer erstaunlichen Verbesserung des Ergebnisses führten. So kann der Schwenkwinkelbereich zwischen 1° und 30° betragen, vorzugsweise zwischen 5° und 15°. Zu einer guten Wirkung trägt auch bei, wenn der Abstand der Düsen von der Leiterplatte nicht zu groß wird, um die Strahlwirkung voll nutzen zu können. Er sollte zwischen 1 und 15 mm, vorzugsweise zwischen 5 und 10 mm betragen, wobei sich dieser Abstand während der Schwenkung ständig ändert.

Als Düsen können Rund-, Schlitz-, Mehrfach- oder Fächerdüsen eingesetzt werden. Der aus ihnen austretende Strahl sollte nach Möglichkeit zumindest in einer Richtung (z.B. bei Schlitzdüsen die Breitenabmessungen) in der Größenordnung des Durchmessers der Löcher in der Leiterplatte liegen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.
Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Ein Ausführungsbeispiel der Erfindung ist in den Zeichnungen dargestellt und wird im folgenden anhand einer Galvanisieranlage näher erläutert. In den Zeichnungen zeigen:
- Fig. 1: einen stark vergrößerten Detailquerschnitt durch einen Sacklochbereich einer Leiterplatte,
- Fig. 2: einen schematischen Längsschnitt durch eine Galvanisiervorrichtung nach der Erfindung und
- Fig. 3 bis 7: verschiedene, für die Erfindung geeignete Düsenrohre mit Düsen, jeweils im Querschnitt und in Teil-Draufsicht.

### BESCHREIBUNG EINES BEVORZUGTEN AUSFÜHRUNGSBEISPIELS

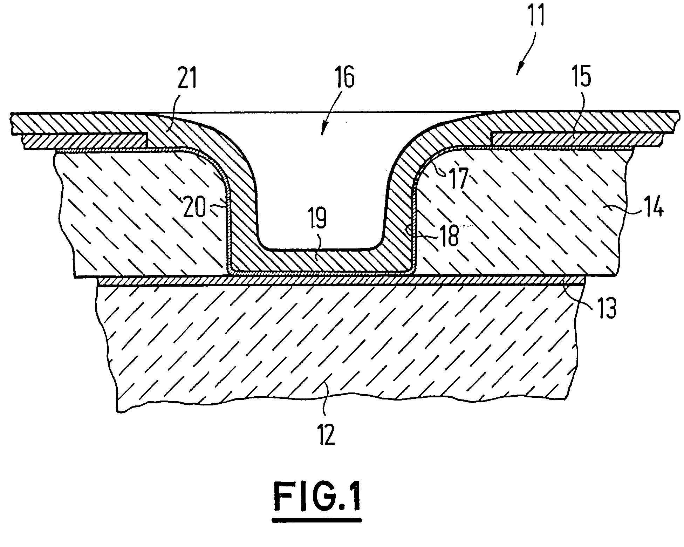

Fig. 1 zeigt einen stark vergrößerten Schnitt durch einen Teil einer Leiterplatte 11. Sie aus mehreren Schichten aus einem isolierenden Material, beispielsweise einem glasfaserverstärkten Kunststoff, aufgebaut, von denen zwei Schichten 12 und 14 gezeigt sind. Die Schichten sind aufeinander laminiert, wobei die untere Schicht 12 eine Basis-Kupfer-Schicht 13 auf ihrer Oberfläche besitzt. Auf diese ist die Schicht 14 auflaminiert, die an ihrer Oberseite ebenfalls eine Basis-Kupfer-Schicht 15 trägt.

In die Schicht 14 ist ein Sackloch 16 eingearbeitet, das durch die Schicht 14 hindurchgeht, jedoch an der Basis-Kupfer-Schicht der unteren Lage endet. Das Sackloch 16 ist durch Laser-Bearbeitung, Plasma-Ätzen oder fotografische Verfahren hergestellt. Die Abmessungen und Schichtdicken sind sehr gering. Die Trägerschichten 12, 14 sind in der Größenordnung von 50 µm dick und die Basis-Kupfer-Schichten 13, 15 haben eine Dicke von 5 bis 7 µm. Die Sacklöcher haben meist einen Durchmesser von 25 bis 100 µm. Die Leiterplatte 11 kann aus zahlreichen übereinander laminierten Schichten bestehen, so dass die Sacklöcher für interne, aber nicht durchgehende Kontaktierung zwischen den einzelnen Kupfer-Schichten zwischen den Lagen dienen.

Die Oberfläche der Leiterplatten-Schicht 14 einschließlich der Kupfer-Schicht 15 sowie die Innenwände und der Boden des Sacklochs sind mit einer chemisch aufgebrachten Kupfer-Schicht 20 überzogen, die eine sehr dünne leitfähige Schicht darstellt und somit den eigentlichen elektrogalvanischen Abtrag der darüber liegenden Kupfer-Schicht 21 ermöglicht. Sie überzieht die Oberfläche der Leiterplatte und die Sacklochwandungen 17. Sie kontaktiert die untere Basis-Kupfer-Schicht 13 im Bereich des Sacklochbodens 19. Statt der Kupferschicht 20 kann auch auf andere Weise die Leitfähigkeit hergestellt werden, z.B. durch Auftrag von Graphit, Palladium oder eines leitfähigen Polymers.

Die in Fig. 1 gezeigte, relativ gleichmäßige und kräftige elektrogalvanisch aufgebrachte Kupfer-Schicht 21 hat eine Dicke von 5 bis 15 µm und ist von relativ gleichmäßiger Dicke.

Dies wird durch die Galvanisierung in der Vorrichtung 25 nach dem im Folgenden beschriebenen Verfahren ermöglicht. Die Vorrichtung 25 weist einen muldenförmigen Galvanisierbehälter 26 auf, der bis zu einem Niveau 28 mit einer Galvanisierflüssigkeit 24 gefüllt ist. Es handelt sich dabei um ein übliches Galvanisierbad, in dem sich Kupferionen in Lösung befinden.

Durch eine Einlass-Schleuse 29 laufen die Leiterplatten 11 in Transportrichtung 40 in die Vorrichtung ein und werden dort von einer Transporteinrichtung 30 horizontal liegend auf einer ebenfalls horizontalen Transportbahn 30 durch die Vorrichtung transportiert. Die Transporteinrichtung besteht aus einer Mehrzahl von oberen und unteren Transportwalzen, die aus einzelnen, auf horizontal liegenden und gegenläufig angetriebenen Wellen aufgereihten Scheiben bestehen. Die leitfähigen Oberflächen der Leiterplatten werden durch Kontaktrollen, Klammern o.dgl. elektrisch kontaktiert.

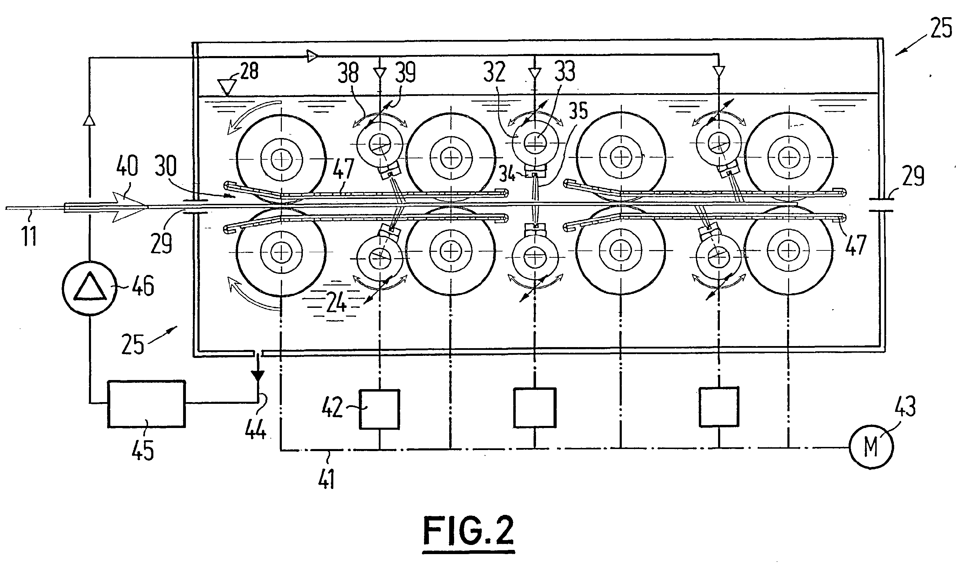

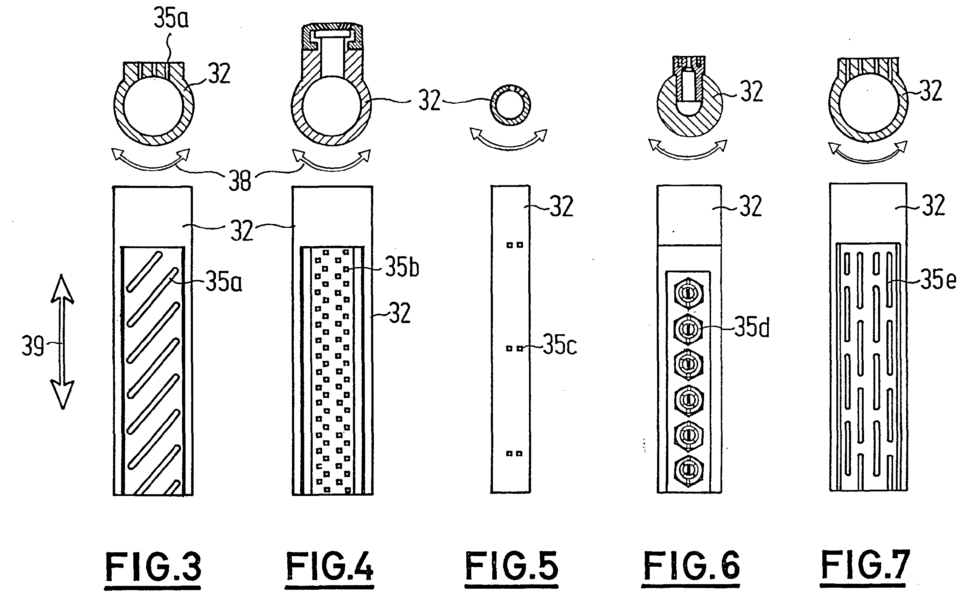

Zwischen den Walzenpaaren 31 sind oberhalb und unterhalb der Transportbahn 30 und unterhalb des Badniveaus 28 Düsenrohre 32 angeordnet, die an ihren den Leiterplatten 11 zugewandten Seiten eine Vielzahl von Düsen 34 aufweisen. Bei den in Fig. 2 angedeuteten Düsen handelt es sich um Düsen ähnlich den in Fig. 6 dargestellten. Sie stehen mit dem inneren Zuführkanal 33 in den Düsenrohren in Verbindung und erzeugen bei Zufuhr von Galvanisierflüssigkeit einzelne Strahlen 35, die auf die Leiterplatten 11 gerichtet sind.

Die Transporteinrichtung, d.h. die Walzenpaare 31 werden über einen in Fig. 2 schematisch angedeuteten Antrieb 41 von einem Elektromotor 43 angetrieben. In der Praxis handelt es sich dabei meist um Zahnriemen oder eine Kette von ineinander eingreifenden Zahnrädern, die in einem Seitenabteil der Mulde 26 laufen. Der Transportantrieb 41 steht über einen Schwenkantrieb 42 mit den Düsenrohren 32 in Verbindung, die quer zur Transportrichtung 40 oberhalb und unterhalb der Transportbahn angeordnet und schwenkbar um ihre Mittelachsen (Pfeil 38) und für eine Oszillationsbewegung (Pfeil 39) längsverschiebbar gelagert sind. Der Schwenk- und Oszillationsantrieb 42 kann beliebige mechanische Getriebe, beispielsweise Kurbel- oder Exzenter-Getriebe, enthalten, die ihren Antrieb von dem Transportantrieb 41 ableiten und daher in einer festen Zuordnung der Transportgeschwindigkeit schwenken. Es sind mehrere, im dargestellten Beispiel drei Paare von schwenkbaren Düsenrohren vorgesehen. In der Praxis sind es wesentlich mehr. Es könnte auch ein von der Transportgeschwindigkeit unabhängiger Antrieb vorgesehen sein.

Das Galvanisierbad wird im Betrieb ständig umgewälzt. Es wird über eine Absaugung 44 aus der Vorrichtung abgesaugt und über eine Badauffrisch-Einrichtung 45 von einer Pumpe 46 in die Zuführkanäle 33 der Düsenrohre gedrückt, wo es mit hoher Geschwindigkeit in Form der Strahlen 35 austritt. In der Badauffisch-Einrichtung 45 werden dem Bad Kupferionen extern zugeführt. Dementsprechend sind die nur strichliert angedeuteten Elektroden 47 im Bad so ausgebildet, dass sie sich nicht auflösen oder abgetragen werden.

Die Figuren 3 bis 7 zeigen unterschiedliche Düsenrohre 32. Es handelt sich in allen Fällen um im wesentlichen runde Rohre, die unterschiedliche Düsenformen aufweisen.

Fig. 3 zeigt schräg angeordnete Schlitzdüsen 35a.

Fig. 4 zeigt eine große Anzahl von Runddüsen 35b geringen Durchmessers, die in vier Reihen nebeneinander angeordnet sind und, wie der Querschnitt zeigt, fächerförmig nach außen gerichtet sind. Dieses Düsenrohr 32 hat einen vorspringenden Steg, in dem die Düsen angeordnet sind. Dieser erzeugt auch eine mechanische "Rührwirkung".

Fig. 5 zeigt ein Düsenrohr 32 mit jeweils in größerem Abstand voneinander angeordneten Düsen 35c in einer Zweier-Gruppierung, die am Umfang des Düsenrohres nebeneinander, ebenfalls leicht fächerförmig weisend in ein Rundrohr eingebohrt sind.

Fig. 6 zeigt Düsen 35d, die als gesonderte Düsenkörper 37 in das Düsenrohr 32 eingeschraubt sind und jeweils zwei axial angeordnete kurze Schlitze als Düsenöffnungen aufweisen.

Schließlich zeigt Fig. 7 eine Anordnung von Schlitzdüsen 35e, die in vier Reihen nebeneinander axial verlaufen und unterschiedliche Schlitzbreiten aufweisen.

### FUNKTION

Zum Galvanisieren von mit Sacklöchern 16 versehenen Leiterplatten 11 werden diese in einem entsprechenden Bad auf chemischem Wege, d.h. durch chemische Reaktion bzw. Ausfällung, mit einem dünnen Überzug 20 aus Kupfer versehen, der auch die aus Isoliermaterial bestehenden Oberflächen der Schichten 12, 14 elektrisch leitend macht. Auch in diesem Verfahrensschritt könnte die Erfindung angewandt werden. Die Leitfähigkeit kann auch durch Aufbringung einer Grafitschicht erzielt werden. Außer den Sachlöchern 16 können die Leiterplatten auch andere Löcher, beispielsweise Durchgangslöcher, enthalten, die jedoch bezüglich der Galvanisierung geringere Probleme darstellen, weil sie durchströmt werden können.

Die so vorbereiteten Leiterplatten, worunter auch aus mehreren übereinander liegenden Schichten bestehende Leiterplatten zu verstehen sind, laufen über die Schleuse 29, durch die Transporteinrichtung 30 geführt, in Transportrichtung 40 in die Vorrichtung 25 (Fig. 2) ein. Dort werden sie von dem Bad benetzt, das durch die ständige Zufuhr von Behandlungsflüssigkeit frisch und in ausreichender Bewegung gehalten wird. Sie durchlaufen dann mehrfach die von beiden Seiten auf die Gegenstände 11 einwirkenden Düsenreihen. Die Düsenrohre 32 werden durch den Schwenk- und/oder Oszillationsantrieb 42 je nach Bedarf in einem Winkelbereich zwischen 1 und 30 (vorzugsweise 1 bis 15°) um die Vertikale geschwenkt, und zwar mit einer solchen Geschwindigkeit, dass vorzugsweise je Millimeter Transportweg eine volle Schwenkperiode durchgeführt wird. Die Strahlen, die vorzugsweise eine Strahlendicke in der Größenordnung der Sacklöcher 16 haben, treffen also in unterschiedlichen Winkeln auf die Sacklöcher. Dies bewirkt nicht nur, dass sie aus unterschiedlichen Richtungen in die Sacklöcher hineinstrahlen, sondern auch, dass eventuell durch Strahlauffächerung an den Lochrändern entstehende Strahabschattung vermieden wird. Ferner wird, da die Strahlen unter der Badoberfläche austreten und auch sonst im Bad verlaufen, das Bad an dieser Stelle gewissermaßen "aufgerührt", so dass auch die nicht direkt im Strahl befindliche Badflüssigkeit eine erhöhte Turbulenz bekommt und somit eine erhöhte Wirksamkeit erzeugt wird.

Es ist zu erkennen, dass die Schwenkbewegungen durchaus nicht synchron ausgeführt werden müssen. Es kann sogar von Vorteil sein, wenn sie auf unterschiedlichen Seiten der Leiterplatten jeweils in unterschiedliche Richtungen zielen, wie dies bei dem in Fig. 2 rechten Düsenpaar zu sehen ist. Dies verhindert eine Anregung von Längsbewegungen des Gegenstandes 11 und ermöglicht auch die bevorzugte Behandlung von Durchgangslöchern, weil dann nicht von beiden Seiten gleichzeitig auf das gleiche Loch gestrahlt wird. Andererseits kann eine synchrone Schwenkbewegung bei sehr dünnen Leiterplatten Ausbeulungsneigungen entgegenwirken.

Die einzelnen Düsenformen sind, jeweils dem Verwendungszweck, der Größe der Löcher etc. angepaßte vorteilhafte Varianten.

Über die Transportwalzen sind die Leiterplatten mit der leitfähigen Schicht 20 an einen Pol der zum elektrochemischen Galvanisieren nötigen Stromquelle angeschlossen. Beim Durchlauf wird die Schicht 21 aufgetragen.

## Patentansprüche

1. Verfahren zur Behandlung von plattenförmigen Gegenständen, insbesondere zum galvanischen Auftrag von Metall, vorzugsweise Kupfer, auf ggf. aus mehreren Schichten aufgebaute Leiterplatten (mit Löchern), insbesondere Sacklöchern (16), bei dem die Leiterplatten in einem Behandlungsbad (24) an Düsen (34) vorbeibewegt werden, aus denen Strahlen (35) von Behandlungsflüssigkeit (24) auf die Leiterplattenoberfläche und die Löcher (16) gerichtet werden, **dadurch gekennzeichnet, dass** während des Vorbeilaufes der Gegenstände (11) die Strahlenrichtung periodisch geändert wird.

2. Verfahren nach Anspruch 1, **dadurch gekennzeichnet, dass** die Periodizität der Strahlenrichtungsänderung eine Frequenz hat, die in Abhängigkeit von der Vorbeilaufgeschwindigkeit der Gegenstände (11) steht und vorzugsweise zwischen 1/cm und 10/mm, vorzugsweise bei 1/mm, liegt.

3. Verfahren nach Anspruch 1 oder 2, **dadurch gekennzeichnet, dass** die Behandlungsflüssigkeit (24) mit einer Austrittsgeschwindigkeit von 0,5 bis 10 m/s aus den Düsen (34) austritt.

4. Vorrichtung zur Behandlung von plattenförmigen Gegenständen (11), insbesondere zum galvanischen Auftrag von Metall, wie Kupfer, auf ggf. aus mehreren Schichten (12, 14) aufgebaute Leiterplatten, mit Löchern, insbesondere Sacklöchern (16), mit einer Transporteinrichtung (30), mit der die Gegenstände (11) durch ein Behandlungsbad (24) und an Düsen (34) vorbeibewegt werden, aus denen Strahlen (35) von Behandlungsflüssigkeit auf die Oberfläche der Gegenstände und die Löcher (16) gerichtet werden, **gekennzeichnet durch** Mittel (42) zum periodischen Schwenk- und/oder Oszillationsantrieb der Düsen (34).

5. Vorrichtung nach Anspruch 4, **dadurch gekennzeichnet, dass** der Schwenkantrieb (41) die Düsen (34) um eine Achse im wesentlichen quer zur Transportrichtung (40) schwenkend antreibt und/oder der Oszillationsantrieb die Düsen (34) im wesentlichen quer zur Transportrichtung (40) oszillierend antreibt.

6. Vorrichtung nach Anspruch 4 oder 5, **dadurch gekennzeichnet, dass** der Schwenk- und/oder Oszillations-Antrieb mit dem Antrieb (41) der Transporteinrichtung (30) gekoppelt ist und eine Schwenk- bzw. Oszillationsfrequenz von 1/cm bis 10/mm, vorzugsweise bei 1/mm aufweist.

7. Vorrichtung nach einem der Ansprüche 4 bis 6, **dadurch gekennzeichnet, dass** die Düsen (34) mit einem Schwenkwinkel 1 und 30°, vorzugsweise 5 bis 15°, geschwenkt werden.

8. Vorrichtung nach einem der Ansprüche 4 bis 7, **dadurch gekennzeichnet, dass** die Düsen (34) unterhalb des Niveaus (28) der Behandlungsflüssigkeit angeordnet sind.

9. Vorrichtung nach einem der Ansprüche 4 bis 8, **dadurch gekennzeichnet, dass** der Abstand der Düsen (34) von den Gegenständen (11) zwischen 1 und 15 mm, vorzugsweise zwischen 5 und 10 mm, liegt.

10. Vorrichtung nach einem der Ansprüche 4 bis 9, **gekennzeichnet durch** eine Vielzahl von Düsen in wenigstens einem schwenkbar und/oder oszillierend angetriebenen Düsenrohr (32).

11. Vorrichtung nach einem der Ansprüche 4 bis 10, **dadurch gekennzeichnet, dass** die Düsen (34) Rund-, Schlitz-, Mehrfach- oder Fächerdüsen sind und vorzugsweise ihre Querschnittsabmessungen in wenigstens einer Richtung in der Größenordnung des Durchmessers der Löcher (16) in der Leiterplatte liegen.

12. Gegenstand, insbesondere Leiterplatte, **dadurch gekennzeichnet, dass** er nach dem Verfahren nach einem der Ansprüche 1 bis 3 hergestellt ist.
